# EUROPEAN PATENT APPLICATION

(11) **EP 1 312 931 A2**
(43) Date of publication of application: **21.05.2003**
(21) Application number: 02257593.0
(22) Date of filing: 01.11.2002
(51) Int. Cl.: G01R 31/3193

(54) **Electronic test system**

(30) Priority: 15.11.2001 US 991020
(71) Applicant: Agilent Technologies, Inc., Palo Alto, CA 94306 (US)
(72) Inventor: Sutton, Christopher K., Everett, WA 9823 (US)
(74) Representative: Jehan, Robert

(57) **Abstract**

An executive test system (100) for testing an electronic device having selectable specifications. A user may select from multiple sets (420, 430, 440) of specifications (323). The selected specification is then applied to test results and a display (309) of the results (310, 311, 312) of the application of the specification is shown.

## Description

This invention relates to an electronic test system preferably suitable for performing automated testing of complex electronic, electro-mechanical, and mechanical devices. The preferred embodiment can allow more than one specification to be applied to results of a test performed upon a device; it can also allow a user to select one of the multiple specifications to apply to results of a test.

Complex electronic, electro-mechanical, and mechanical devices are generally tested using automated test systems. The tests may include validation tests which run through the various operations of a device under test (DUT) and records whether each operation was performed properly. The tests may also include environmental tests which expose the DUT to various combinations of temperature, pressure, and humidity. The results of operations are recorded as the environment changes. Other tests, such as production tests, may be completed. Generally, both the DUT and the systems providing the environmental and other constraints on the DUT are controlled electronically. In the last decade or so, computerized programs which are capable of controlling a variety of automated tests, referred to in the art as "test executive" programs, have been developed.

Test executive programs in the prior art include internal test executive programs developed by Agilent Technologies and TESTSTAND software developed by National Instruments Corporation, which is described as a ready-to-run test executive program for organizing, controlling and executing automated prototype, validation, or production test systems. The prior art Agilent Technologies test systems do not use a graphical user interface (GUI), which limits the ability of the program to display large amounts of data in a simple fashion. The TESTSTAND software, while using a GUI, requires the user to scroll through multiple windows to determine the overall progress of a test.

Tests usually are defined by a set of rules or specifications to which the DUT is compared. The rules and specifications generally comprise various inputs defined by electrical and mechanical parameters applied to the DUT, such as voltage, current, specified manipulations of controls and device parts, as well as environmental parameters under which the test is conducted, such as temperature, humidity, pressure, and the time period over which a parameter is applied. Each test will include many combinations of the parameters applied to each element of the DUT, and often will be repeated many times. Each combination of parameters will define a measurement that results in one or more datapoints, which are recorded and compared to numerical or boolean limits defining the specifications. Thus, as devices become more complex, electronic test programs have become very long and complex, often requiring several days, or even a week or more to complete a test.

Sometimes an electronic device must meet different specifications for different applications. For example, an electronic device sold to the United States Air Force may have to meet different specifications than an electronic device sold for home or commercial use. Heretofore, there is no way to use different specifications on a DUT in the prior art. In order to use different specifications, different specifications had to be entered on a one-to-one basis in the prior art or a separate test had to be executed for each set of specifications.

The present invention seeks to provide improved testing.

According to an aspect of the present invention there is provided an electronic test system as specified in claim 1.

According to another aspect of the present invention there is provided a method of operating a test executive program as specified in claim 6.

The preferred electronic test program provides selectable specifications which allows a user to select a set of specifications for a particular test of a DUT. The set of specifications is then applied to results of the test. Therefore, different specifications is then applied to results of the test. Therefore, different specifications may be applied to results of a test without having to execute the test again or individually change the specifications.

One skilled in the art will recognize that the instructions for the processes or method disclaimed herein may be stored in a memory as software instructions, may be fixed hardware, or stored as firmware. The processes of this application operate in the following manner in a preferred exemplary embodiment of this invention. A user selects a settings option in a menu. The menu is a toolbar on the GUI. When the setting options is selected, a menu having multiple options including specifications options is displayed.

The user then selects the specification options in the setting menu displayed. In response to receiving a selection of the specification option, the processing unit determines which device is the DUT and which tests are being performed on the DUT. The specifications available for the test being performed are then determined and a menu including the specifications available is displayed.

The user then selects a specification to apply to the results of the tests. The processor applies the specifications to the results of the tests performed on the DUT. A display is then updated showing the results of the application of the selected specifications to the results of tests.

There may also be provided a product that provides a test executive program for controlling a test on a device, the product comprising: instructions for directing a processing unit to receive a selected one of a plurality of alternative specifications for assessing a datapoint generated by a test, and apply the selected specification to the datapoint generated by the test; and a media readable by the processing unit that stores the instructions. Preferably, the instructions further comprise: instructions for directing the processing unit to receive a request for a display of the plurality of specifications available, determine the plurality of specifications available, and display the plurality of specifications. Preferably, the request comprises the selection of an option of a displayed menu. Preferably, a plurality of. specifications available is displayed on a menu. Preferably, the received selected specification is received as a choice from the menu of the plurality of specifications available. Preferably, the instructions for determining the plurality of specifications available comprises instructions for directing the processing unit to determine the device being tested. Preferably, the instructions for determining the plurality of specifications available comprises instructions for directing the processing unit to determine the test being applied to the device.

A preferred method for providing a test executive program that controls a test applied to a device comprises the steps of: receiving a selected one of a plurality of alternative specifications for assessing a datapoint generated by a test; and applying the selected specification to the datapoint generated by the test. Preferably, the method further comprises the steps of: receiving a request for a display of the plurality of specifications available, determining the plurality of specifications available, and displaying the plurality of specifications. Preferably, the request is a selection of an option of a displayed menu. Preferably, the plurality of specifications available is displayed on a menu. Preferably, the step of receiving a selected specification is received as a choice from the menu of the plurality of specifications available. Preferably, the step of determining the plurality of specifications available comprises the step of determining the device being tested. Preferably, the step for determining the plurality of specifications available comprises the step of determining the test being applied to the device. Preferably, the method further comprises the step of updating a display of the results compared to the selected specification.

In another embodiment there is provided an electronic test system comprising: a storing medium storing a test to be performed on a product other than the test system, a plurality of test datapoints resulting from the test, and a plurality of sets of alternative specifications for accessing the datapoints; an input device for selecting one of the sets of alternative specifications; a processor responsive to the input device for receiving the set of specifications and comparing them with the datapoints; and an output device for presenting the results of the comparison. Preferably, the input device comprises a menu on a display and a manual device for selecting an item on the menu. Preferably, the output device comprises a display. Preferably, the storing medium comprises an electronic memory. Preferably, the stored test includes an operational test and an environmental test.

The preferred embodiment not only permits different sets of specifications to be applied to a test, but also has many other advantages: for example, if a new customer provides an altered set of specifications and there is a product already built for which tests have been run and the results stored, it can quickly be determined which of the products will be satisfactory to the customer.

Am embodiment of the present invention is described below, by way of example only, with reference to the accompanying drawings, in which:
FIG. 1 illustrating a block diagram of hardware components that execute an electronic test program in accordance with an embodiment of this invention;
FIG. 2 illustrating a block diagram showing a hierarchical structure of a test executive program in accordance with an embodiment of this invention;
FIG. 3 illustrating a view of a graphical user interface (GUI) of an electronic executive test program according to an embodiment of the invention;
FIG. 4 illustrating a view of a GUI of an electronic executive test program and menus for specification selection in accordance with an embodiment of this invention; and
FIG. 5 illustrating a flow diagram for an application that provides specification selection.

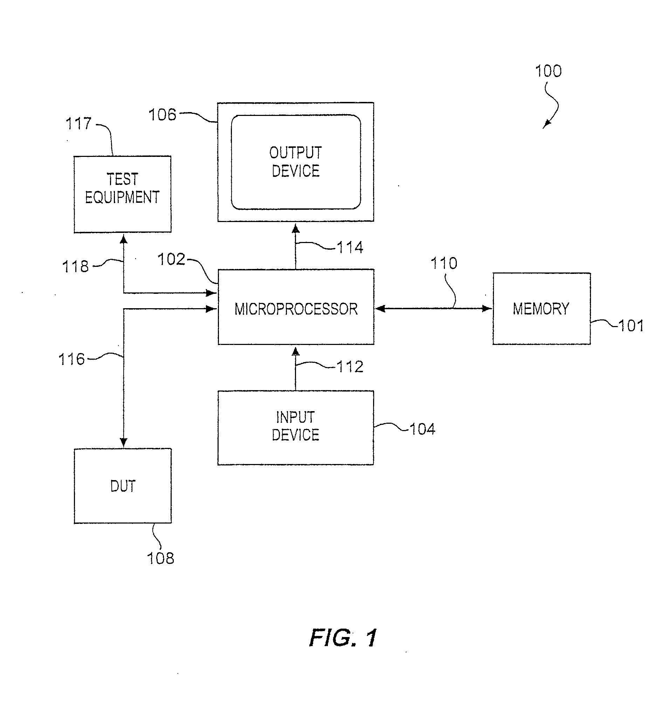

The described embodiment relates to an electronic test executive program. FIG. 1 illustrates a computer system 100 that executes test executive programs.

Computer system 100 includes memory 101, microprocessor 102, input device 104 and output device 106. Memory 101 connects to microprocessor 102 via path 110. Memory 101 may be a non-volatile memory such as a Read Only Memory (ROM) or a volatile memory such as a Random Access Memory (RAM). Input device 104 connects to microprocessor 102 via path 112. Input device 104 may be a keyboard, mouse, joystick, or any other device and software driver that allows a user to input data.

In a preferred embodiment, the test executive program is stored as instructions in memory 101. Those skilled in the art will recognize that the instructions may either be stored as computer software and/or firmware that is readable and executable by microprocessor 102. The results for a test performed by the test executive program are displayed on output device 106. Output device 106 is a display and associated drivers that allow an application to display images to a user. Those skilled in the art will recognize that the display may be a conventional cathode ray monitor or Liquid Crystal Display (LCD). The actual display used does not matter.

Microprocessor 102 executes the test executive program. Microprocessor 102 communicates with a Device Under Test (DUT) 108 via path 116. Microprocessor 102 controls the test equipment 117 via electrical line 118. Signals received via path 116 by microprocessor 102 are saved for use in memory 101.

One skilled in the art will recognize that this system may be implemented by any electronic device having the same general configuration outline in FIG. 1. These electronic devices include, but are not limited to, a computer system, logic circuits embedded in hardware, and an electronic analyzer.

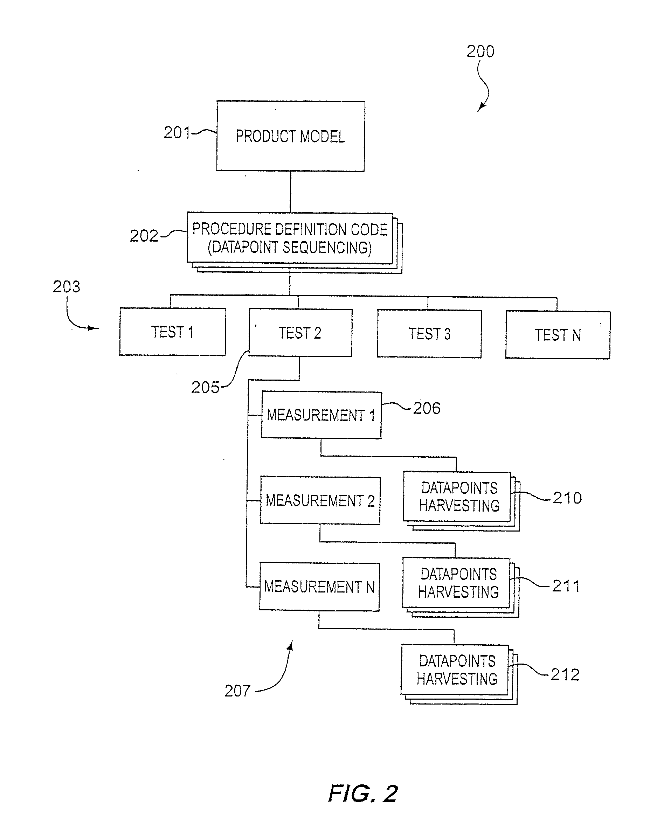

To better understand this invention, a hierarchical structure of a test executive program is described in FIG. 2. Block diagram 200 illustrates a hierarchical, multi-level structure of the preferred embodiment of the test executive program.

First level 201 corresponds to a product model which is a file that a test developer creates to test a family of specific device model numbers. This file contains test procedures and inputs. Second level 202 is a group of procedures. A procedure is an ordered list, sequence, or script of tests to be run on a device. Test 203 is the next level that includes tests 1 - N to be run in each procedure 202. Each test 203 in turn includes a plurality of measurements to be taken during a test 203. For example, test 205 includes measurements 206. Each measurement 1 - N includes one or more datapoints 214. For example, measurement 207 includes datapoints 210 - 212.

Each procedure 202 is defined by a written program or a code used to build a structure of software objects. In one embodiment, the software objects are component object models, or COM. COM is a language independent component architecture, not a programming language. COM is meant to be a general purpose, object-oriented structure to encapsulate commonly used functions and services.

A test 203 is a group of measurements in a procedure 202 that share a common testing algorithm or the same test software code. Some examples of tests 203 include, but are not limited to, an amplitude accuracy test, or a test of harmonic distortion. Test executive program 200 repeatedly calls a test for each measurement and datapoint.

A measurement 206 is a configuration or a set up of a test. Each measurement 206 within a test 203 can have different setup or configuration parameters. Tests 203 are parameter driven. Parameters are input at a measurement level. Measurements 206 are elements such as range in volts, frequency in kilohertz, or a harmonic (an integer number).

Each procedure 202 uses measurements 206 as data to be passed from the procedure to a test. A measurement is also a phase of execution. During a measurement phase of execution of a test 203, a measurement is started but data is not collected. Therefore, multiple DUTs 108 may be configured and tested concurrently.

Test 205 and a second test 203 may include the same measurements 206. For example, test 205 tests amplitude accuracy for a voltage measurement and a frequency measurement. The second test checks an amplitude accuracy for a voltage measurement and a frequency measurement. There may also be a third test that tests harmonic distortion for a frequency measurement or harmonics of a signal.

Datapoints 210 - 212 are a subset of a measurement. These datapoints 210 - 212 include additional parameters that select a result when one measurement generates multiple results. For example, a measurement may have minimum and maximum datapoints for a spectrum analyzer sweep or different datapoints for each channel of a device. For each datapoint 210 - 212, a value result is determined. The datapoint is accessed by comparing the value result to the specification. Specifications may include numerical limits, string match, and/or Boolean pass/fail results. There may be three different types of numerical limits including marginal limits, line limits, and customer limits. Each limit has an upper value and a lower value.

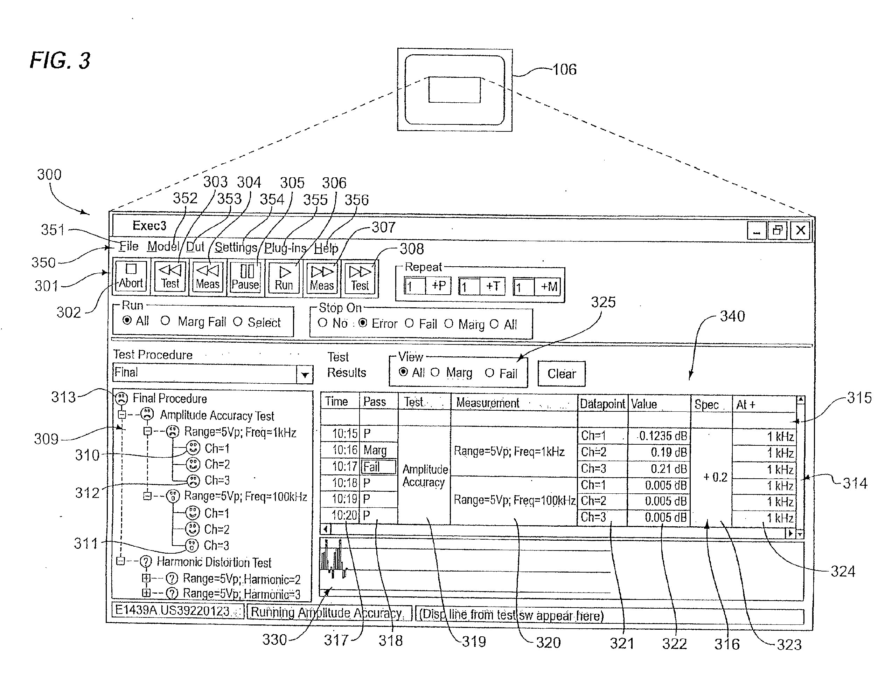

All inputs and outputs of computer system 100 (FIG. 1) executing a test executive program are handled through a Graphical User Interface (GUI). FIG. 3 illustrates a GUI 300 as displayed by output device 106 in accordance with an embodiment of a test executive program. GUI 300 includes buttons 301 that are used to control a test. For the convenience of the user, buttons 301 have indicia that indicate the function served by a button. For example, buttons 301 appear as tape recorder buttons in accordance with a preferred embodiment of this invention. In the preferred embodiment, these buttons include abort button 302, restart test button 303, restart measurement button 304, pause button 305, run button 306, skip measurement button 307, and skip test button 308. One skilled in the art will recognize that while tape recorder symbols are used in this embodiment, any number of different indicia may be used to identify buttons 301.

Area 314 on the right side of GUI 300 in the preferred embodiment is a display of test results. In the preferred embodiment, area 314 includes a series of rows 315 and columns 316 displaying results 340 of individual tests. Column 317 indicates the time that a test is executed. Column 318 displays a status of the test. Column 319 also displays a name of a test. For example, one test is an amplitude frequency. Column 320 indicates a type of measurement being taken during a test. For example, range = 5Vp; frequency = 1 kHz. Column 321 displays the channel or datapoint under test. For example, ch=1 or ch=2. Column 322 displays a value or result of the test for a channel or datapoint. Column 323 displays a specification, such as +0.2. Column 324 displays a parameter such as 1 kHz.

Buttons 325 facilitate the sorting of displayed tests to allow a user to view desired tests. In the preferred embodiment, buttons 325 include an all button, a marginal pass button, and a fail button. However, one skilled in the art will recognize any number of additional ways to view the data may be added. Area 330 displays a progress bar that represents progress of a procedure being executed.

In the preferred embodiment, area 309 illustrates a test tree 313 that represents the tests being performed in a procedure area 309 and includes a hierarchy of tests, measurements, and datapoints. Test tree 313 includes icons 310, 311, 312 that indicate a status of a test, i.e., the result of an assessment of datapoints. The icons indicate pass, fail, marginal, and not-yet tested. In a preferred embodiment, a "smiley face" indicates a pass, a "surprised face" indicates a marginal pass, and a "frowning face" indicates a fail. The icon for the procedure indicates the status of the entire procedure. While icons for each test represent the status of an individual test, the icon for the procedure is determined by an algorithm that promotes the least optimal result. Thus, if one test fails, the procedure fails.

GUI 300 also includes a menu bar 350. Menu bar 350 displays a list of menu options for controlling the test executive program. Menu bar 350 includes file menu 351, model file 352, DUT menu 353, setting menu 354, plug-in menu 355 and help menu 356. File menu 351 includes a list of options for opening and closing files for use with the test executive program. Model menu 352 displays a list of model families that may be tests. DUT menu 353 displays a screen for entry of a DUT model, serial number, options and other information for identifying a DUT. Settings menu 354 displays a menu for viewing and changing executive settings. Plug-in menu 355 displays a user interface for a plug-in loaded into the system. Help menu 356 displays a list of help functions available in the test executive program.

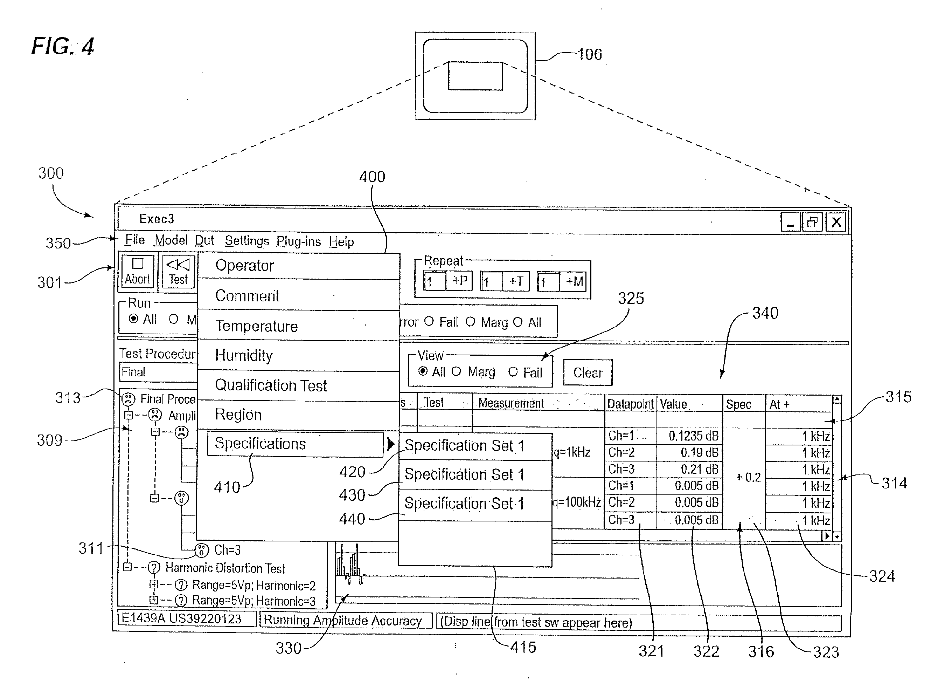

FIG. 4 illustrates a screen displayed when settings menu 354 is selected. Settings menu 354 may be selected by clicking on the word "settings" or typing the letter "s." When settings menu 354 is selected, drop down menu 400 is displayed. Drop down menu 400 includes options for changing executive settings of the program. Specifications selection option 410 is one of the options in drop down menu 400.

The specifications menu 415 is selected by clicking on specification menu 410 in drop down menu 400. When specification menu 410 is selected, specification drop down menu 415 is displayed. Drop down menu 415 includes sets of specifications 420, 430, and 440. One skilled in the art will recognize that sets of specifications 420, 430, and 440 may have names that identify the type of use that the specification is testing. For example, specification set 420 may be labeled military, specification set 430 may be labeled commercial, and specification set 440 may be labeled retail. The specification sets displayed are determined by the device under test, and the test being executed on the device.

When a specification set is selected, the test executive program accesses the datapoints representing the results of a test by comparing the specification parameters to the test results for the datapoints. GUI 300 is then updated to show the results of the assessment using the selected specification set. For example, the icons of test tree 313 are updated (FIG. 3), and the "Pass" and "Spec" columns in area 314 are updated.

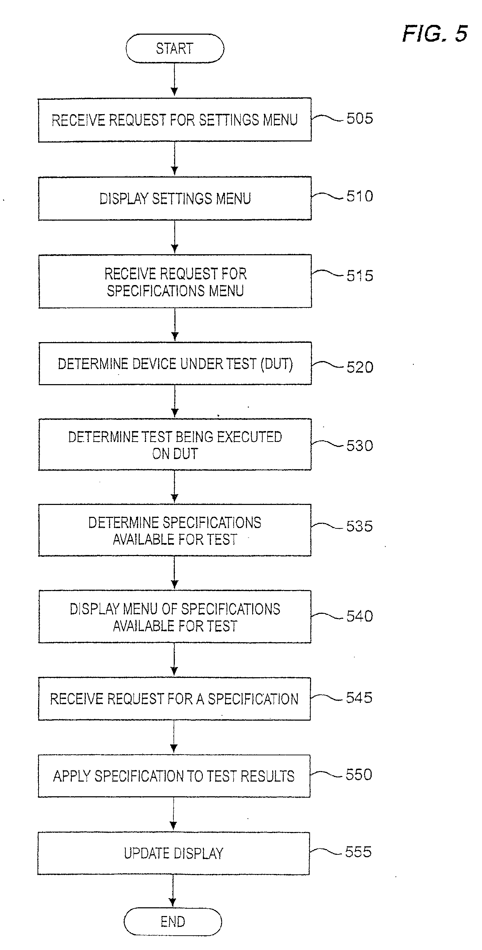

FIG. 5 illustrates a flow chart for a process 500 for providing specification selection in accordance with a preferred exemplary embodiment of this invention. Process 500 begins in step 505 with the processing unit receiving a request for the settings menu. One skilled in the art will recognize that the request may be a mouse click on the setting menu display 354 of GUI 300 or the input of an alphanumeric designation of setting menu 354. In step 510, the processing unit displays the setting menu as drop down menu 400. The processing unit receives a request for the specifications menu 410 in step 515.

In response to receiving the request for the specifications menu, the processing unit determines the Device Under Test (DUT) in step 520. In step 525, the processing unit determines the test being executed on the DUT. The specifications available for the test being executed on the DUT are determined in step 530 in response to the DUT and test being executed being determined. In step 540, the menu of specifications available for the test are displayed.

In step 545, a request for a specification is received. In response to receiving a request, the processing unit applies the specifications to the results of the test. Process 500 then ends in step 555 with the processing unit updating the display to show the results of applying the specifications to the test results.

The above is a description of a preferred exemplary embodiment of a test executive program that provides specification selection. It is envisioned that those skilled in the art can and will design alternative test executive programs that provide specification selection that infringes on this invention as set forth in the claims below either literally or through the Doctrine of Equivalents.

The disclosures in United States patent application No. 9/991,020, from which this application claims priority, and in the abstract accompanying this application are incorporated herein by reference.

## Claims

1. An electronic test system (100) including a storing medium (101) storing a test to be performed on a product (108) other than said test system, a plurality of test datapoints (210, 321) resulting from said test, and specifications (410, 323) for accessing said datapoints; a processor (102) communicating with said storing medium for receiving said set of specifications and for comparing them with said datapoints; and an output device (106) for presenting the results (309, 318) of said comparison; wherein said storing medium stores a plurality of different alternative sets (420, 430, 440) of said specifications for accessing said datapoints; and said system includes an input device (104) for selecting one of said alternative sets of said specifications.

2. A system as in claim 1, wherein said input device comprises a menu (415) on a display and a manual device (104) for selecting an item on said menu.

3. A system as in claim 1 or 2, wherein said plurality of sets of alternative specifications includes: a first plurality of said sets, each corresponding to a different device to be tested; and a second plurality of said sets, each corresponding to a different test that can be applied to one of said devices.

4. A system as in any one of claims 1, 2 or 3, wherein said output device comprises a display (106) and said storing medium comprises an electronic memory (101).

5. A system as in any preceding claim, wherein said stored test includes an operational test and an environmental test.

6. A method of operating a test executive program (200) that controls a test applied to a device (108), including the steps of:
receiving a selected one of a plurality of alternative specifications (420, 430, 440) for assessing a datapoint (210, 321) generated by a test; and
applying said selected specification to said datapoint generated by said test.

7. A method as in claim 6, wherein said receiving step includes:
accepting a request for a display of said plurality of specifications available;
determining said plurality of specifications available;
displaying said plurality of specifications on a menu (415); and
selecting one of said plurality of specifications available.

8. A method as in claim 7, wherein said step of determining said plurality of specifications available comprises the step of determining said device being tested.

9. A method as in claim 7 and 8, wherein said step of determining said plurality of specifications available comprises of a step of determining said test being applied to said device.

10. A product that provides a test executive program (200) for controlling a test on a device, said product including:
instructions for directing a processing unit (102):
receive a selected one of a plurality of alternative specifications (420, 430, 440) for assessing a datapoint (210, 321) generated by a test, and
apply said selected specification to said datapoint generated by said test; and
a media (101) readable by said processing unit that stores said instructions.
